# EUROPÄISCHE PATENTANMELDUNG

(11) **EP 0 678 981 A2**
(43) Veröffentlichungstag der Anmeldung: **25.10.1995**
(21) Anmeldenummer: 95105797.5
(22) Anmeldetag: 19.04.1995
(51) Int. Cl.: H03J 3/08, H03J 5/24

(54) **Hochfrequenz-Empfangsstufe**

(30) Priorität: 21.04.1994 DE 4413927; 16.03.1995 DE 19509567
(71) Anmelder: Philips Patentverwaltung GmbH, 22335 Hamburg (DE); Philips Electronics N.V., 5621 BA Eindhoven (NL)
(72) Erfinder: Ruitenburg, Leo, D-20097 Hamburg (DE)
(74) Vertreter: Peters, Carl Heinrich, Dipl.-Ing.

(57) **Zusammenfassung**

Beschrieben wird eine Hochfrequenz-Empfangsstufe (Tuner) mit wenigstens zwei Signalverarbeitungszweigen zum frequenzselektiven Empfangen, Verstärken und/oder Frequenzmischen von Hochfrequenzsignalen mit einer Umschaltstufe, über die von einem Eingang zuführbaren Hochfrequenzsignale wahlweise auf einen der Signalverarbeitungszweige geleitet werden können, sowie in jedem Signalverarbeitungszweig weiterhin je einer an die Umschaltstufe angeschlossenen Filterstufe, einer der Filterstufe nachgeschalteten, steuerbaren Verstärkerstufe und einer an die Verstärkerstufe sich anschließenden Mischstufe, wobei die Mischstufen mit ihren Ausgängen über eine Signalzusammenführung an einen gemeinsamen Ausgangszweig angeschlossen sind.

Dadurch wird eine Anordnung mit verringertem Bauvolumen und reduzierten Herstellungskosten ermöglicht.

## Beschreibung

Die Erfindung bezieht sich auf eine Hochfrequenz-Empfangsstufe.

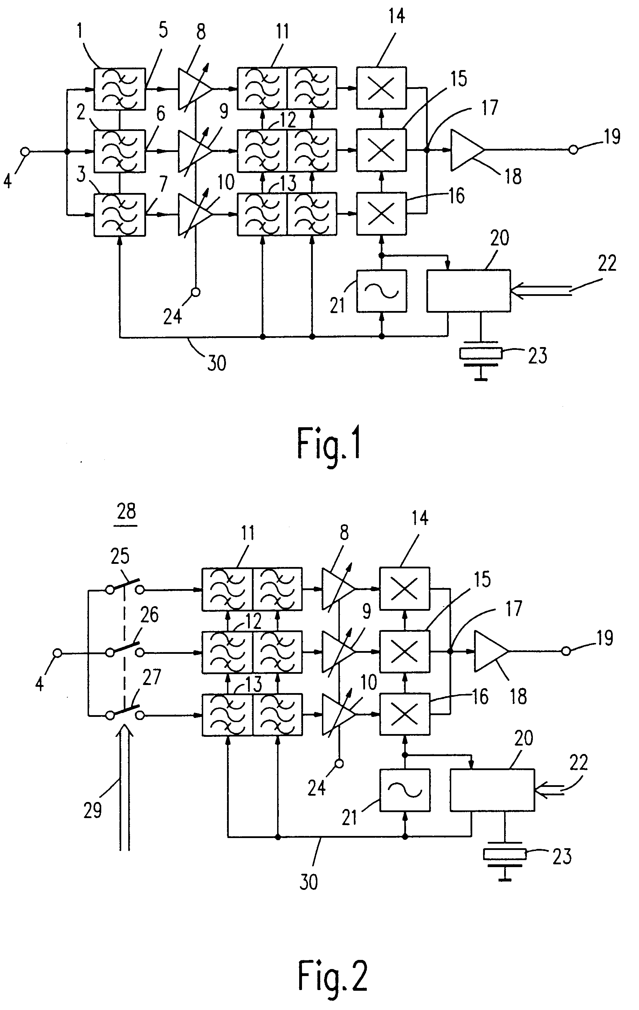

Bei Hochfrequenz-Empfangsstufen (Tunern), die wenigstens zwei Signalverarbeitungszweige zum Verarbeiten von Hochfrequenzsignalen vorzugsweise verschiedener Frequenzbänder umfassen, ist nach einem bisher gebräuchlichen Konstruktionsprinzip an einen Eingang, über den Hochfrequenzsignale z.B. von einer Antenne zuführbar sind, für jedes der Frequenzbänder erste Filterstufen angeordnet, durch die die zugeordneten Frequenzbänder selektiert werden. Eine derartige Schaltungsanordnung ist in Fig. 1 dargestellt; die ersten Filterstufen sind dort mit den Bezugszeichen 1, 2 und 3 versehen, der Eingang für die Hochfrequenzsignale trägt das Bezugszeichen 4. An Ausgängen 5, 6, 7 der ersten Filterstufen 1, 2, 3 sind dann Hochfrequenzsignale ausschließlich des ausgefilterten Frequenzbandes abgreifbar. Diese werden über eine steuerbare Verstärkerstufe 8, 9 bzw. 10 und daran sich anschließende Filterstufen 11, 12 bzw. 13 zugehörigen Mischstufen 14, 15 bzw. 16 zugeleitet und darin in ihrer Frequenz herabgemischt. Über eine Signalzusammenführung, in der Anordnung nach Fig. 1 gebildet durch einen Leitungsknoten 17 und einen Ausgangsverstärker 18, sind die herabgemischten Hochfrequenzsignale einem gemeinsamen Ausgang 19 zuführbar. Begrifflich kann dabei wahlweise die Signalzusammenführung auch nur den Leitungsknoten 17 umfassen; der Ausgangsverstärker 18 gehört zusammen mit dem Ausgang 19 bereits zu einem für alle Signalverarbeitungszweige gemeinsamen Ausgangszweig.

Zur Erzeugung der zum Herabmischen der Hochfrequenzsignale benötigten Schwingung dient in der Anordnung nach Fig. 1 ein gemeinsamer Schwingungsgenerator, der eine phasenverriegelte Schleife 20 und eine Oszillatorstufe 21 umfaßt, die in an sich bekannter Weise miteinander verbunden sind. Über einen Dateneingang 22 ist die Frequenz der vom Schwingungsgenerator abgegebenen Schwingung einstellbar. Der Schwingungsgenerator 20, 21 ist ferner mit einem Kristalloszillator 23 als Frequenzreferenz verbunden.

Die steuerbaren Verstärkerstufen 8, 9, 10 weisen einen Steuereingang 24 auf, über den die Verstärkung der Verstärkerstufen 8, 9, 10 einstellbar ist. Die steuerbaren Verstärkerstufen 8, 9, 10 können dann in eine Regelschleife zur Amplitudenregelung der Hochfrequenzsignale eingebunden werden.

Die Erfindung hat die Aufgabe, eine Hochfrequenz-Empfangsstufe der in Fig. 1 gezeigten Art derart auszugestalten, daß sie für eine weitere Vereinfachung des Aufbaus und eine Verringerung des dafür benötigten Bauvolumens geeignet ist.

Diese Aufgabe wird gelöst durch eine Hochfrequenz-Empfangsstufe (Tuner) mit wenigstens zwei Signalverarbeitungszweigen zum frequenzselektiven Empfangen, Verstärken und/oder Frequenzmischen von Hochfrequenzsignalen mit einer Umschaltstufe, über die von einem Eingang zuführbaren Hochfrequenzsignale wahlweise auf einen der Signalverarbeitungszweige geleitet werden können, sowie in jedem Signalverarbeitungszweig weiterhin je einer an die Umschaltstufe angeschlossenen Filterstufe, einer der Filterstufe nachgeschalteten, steuerbaren Verstärkerstufe und einer an die Verstärkerstufe sich anschließenden Mischstufe, wobei die Mischstufen mit ihren Ausgängen über eine Signalzusammenführung an einen gemeinsamen Ausgangszweig angeschlossen sind.

Mit den in der Vergangenheit verfügbaren Filterstufen und Verstärkerstufen war es zum Erreichen genügend hoher Amplituden der empfangenen Hochfrequenzsignale und ausreichend hoher Signal-Rausch-Verhältnisse erforderlich, möglichst unmittelbar nach einer ersten Frequenzselektion eine Verstärkung der empfangenen Hochfrequenzsignale vorzunehmen. Die Frequenzselektion war jedoch im Anschluß an die Verstärkung noch nicht ausreichend, um bei einer anschließenden Herabmischung auftretende, unerwünschte Harmonische wirksam unterdrücken zu können. Daher waren zwischen die Verstärkerstufen und die Mischstufen weitere Filterstufen eingefügt, die die Frequenzselektion der Frequenzbänder verbessern sollten.

Bei einer Integration insbesondere aller Halbleiterbauelemente einer derartigen Hochfrequenz-Empfangsstufe ergibt sich jedoch der Nachteil, daß ein derartiges integriertes Bauteil Eingangsanschlüsse und Ausgangsanschlüsse für die Verstärkerstufen sowie Eingangsanschlüsse für die Mischstufen aufweisen muß. Die Anzahl der Anschlüsse eines integrierten Bauteils beeinflußt jedoch dessen Kosten in hohem Maße. Insbesondere für Massenanwendungen sind daher stets mit möglichst wenigen Anschlüssen zu bevorzugen.

Die Erfindung macht sich die Erkenntnis zugrunde, daß insbesondere in modernen Filterstufen eine derart hohe Frequenzselektion bei gleichzeitig niedrigem Signal-Rausch-Verhältnis und insbesondere eine derart niedrige Signaldämpfung erreicht werden kann, daß eine Verstärkung erst nach einer vollständigen Frequenzselektion erforderlich ist. Daher können in der Reihenfolge der Stufen der Signalverarbeitungszweige die Filterstufen an den Anfang rücken und die Verstärkerstufen mit den Mischstufen verbunden werden. Es ist dann sehr einfach möglich, die Verstärkerstufen und die Mischstufen zu einem kompakten Bauteil mit wenigen Anschlüssen zusammenzufassen. Dadurch werden Kosten und Bauvolumen einer derart ausgebildeten Hochfrequenz-Empfangsstufe bedeutend verringert. Zur Unterdrückung jeweils nicht erwünschter Frequenzbänder dient in einer solchen Anordnung die Umschaltstufe, über die nur jeweils einem der Signalverarbeitungszweige zur Zeit ein Hochfrequenzsignal zugeleitet wird. Diese Umschaltstufe ist sehr einfach und preiswert ausführbar.

Zur weiteren Verringerung des Bauvolumens und der Herstellungskosten können die steuerbaren Verstärkerstufen und die Mischstufen aller Signalverarbeitungszweige in einem integrierten Bauteil zusammen mit einem allen Mischstufen gemeinsamen Schwingungsgenerator zusammengefaßt werden. Dabei können in diesem integrierten Bauteil eine vom Schwingungsgenerator umfaßte phasenverriegelte Schleife und eine ebenfalls umfaßte Oszillatorstufe enthalten sein. Vorzugsweise ist dann lediglich ein als Kristalloszillator ausgebildetes Frequenzelement, welches mit dem Schwin gungsgenerator verbunden ist, an das integrierte Bauteil anzuschließen.

Bevorzugt ist das integrierte Bauteil als integrierte Halbleiterschaltung ausgeführt.

Ein Ausführungsbeispiel der Erfindung ist in Fig. 2 dargestellt und wird im nachfolgenden näher beschrieben. Dabei sind zu Fig. 1 erläuterte Elemente wieder mit denselben Bezugszeichen versehen.

Bei der Hochfrequenz-Empfangsstufe des Ausführungsbeispiels nach Fig. 2 stimmt die Anordnung der Mischstufen 14, 15, 16, des Leitungsknotens 17, des Ausgangsverstärkers 18, des Ausgangs 19, des Schwingungsgenerators 20, 21, des Dateneingangs 22, des Kristalloszillators 23 und des Steuereingangs 24 mit derjenigen nach Fig. 1 überein. Erfindungsgemäß sind jedoch in den Signalverarbeitungszweigen die steuerbaren Verstärkerstufen 8, 9, 10 und die zu Fig. 1 schon beschriebenen Filterstufen 11, 12, 13 in ihrer Reihenfolge vertauscht. Demzufolge enthält jeder Signalverarbeitungszweig zwischen dem Eingang 4 für die Hochfrequenzsignale und dem Leitungsknoten 17, aufgezählt in ihrer Reihenfolge bezüglich des Durchlaufs der Hochfrequenzsignale, einen Schaltkontakt 25, 26 bzw. 27 der Umschaltstufe 28, die Filterstufe 11, 12 bzw. 13, die steuerbare Verstärkerstufe 8, 9 bzw. 10 und die Mischstufe 14, 15 bzw. 16. Die Schaltkontakte 25, 26, 27 der Umschaltstufe 28 werden über eine Datenleitung 29 entsprechend dem ausgewählten Frequenzband wahlweise leitend bzw. gesperrt geschaltet, so daß stets nur einer der Signalverarbeitungszweige mit dem Eingang 4 verbunden ist; d.h. nur jeweils einer der Schaltkontakte 25, 26 bzw. 27 ist leitend. Die Datenleitung 29 kann ebenso wie der Dateneingang 22 mit einer nicht dargestellten Steuerung für den Empfangsbetrieb der Hochfrequenz-Empfangsstufe verbunden sein.

Die Filterstufen 11, 12, 13 sind über eine Leitung 30 mit der phasenverriegelten Schleife 20 verbunden. Über diese können in an sich üblicher Weise Referenzschwingungen für die Frequenzselektion vom Schwingungsgenerator 20, 21 zugeführt werden.

Eine bevorzugte Anwendung dieser Hochfrequenz-Empfangsstufen liegt bei Hochfrequenz-Verarbeitungsstufen von Satelliten-Empfangsanlagen und Videorekordern.

## Patentansprüche

1. Hochfrequenz-Empfangsstufe (Tuner) mit wenigstens zwei Signalverarbeitungszweigen zum frequenzselektiven Empfangen, Verstärken und/oder Frequenzmischen von Hochfrequenzsignalen mit einer Umschaltstufe, über die von einem Eingang zuführbaren Hochfrequenzsignale wahlweise auf einen der Signalverarbeitungszweige geleitet werden können, sowie in jedem Signalverarbeitungszweig weiterhin je einer an die Umschaltstufe angeschlossenen Filterstufe, einer der Filterstufe nachgeschalteten, steuerbaren Verstärkerstufe und einer an die Verstärkerstufe sich anschließenden Mischstufe, wobei die Mischstufen mit ihren Ausgängen über eine Signalzusammenführung an einen gemeinsamen Ausgangszweig angeschlossen sind.

2. Hochfrequenz-Empfangsstufe (Tuner) nach Anspruch 1, dadurch gekennzeichnet, daß die Mischstufen aller Signalverarbeitungszweige mit einem gemeinsamen Schwingungsgenerator verbunden sind.

3. Hochfrequenz-Empfangsstufe (Tuner) nach Anspruch 2, dadurch gekennzeichnet, daß der Schwingungsgenerator eine phasenverriegelte Schleife und eine Oszillatorstufe umfaßt.

4. Hochfrequenz-Empfangsstufe (Tuner) nach Anspruch 3, dadurch gekennzeichnet, daß die steuerbaren Verstärkerstufen und die Mischstufen aller Signalverarbeitungszweige zusammen mit dem Schwingungsgenerator in einem integrierten Bauteil zusammengefaßt sind.
